# EUROPEAN PATENT SPECIFICATION

(11) **EP 1 085 106 B1**
(45) Date of publication and mention of the grant of the patent: **17.01.2007**
(21) Application number: 00119280.6
(22) Date of filing: 06.09.2000
(51) Int. Cl.: C23C 16/448, B01F 3/02, B01D 3/34

(54) **A method and an apparatus for gasifying a liquid material**
Verfahren und Vorrichtung zum Überführen eines flüssigen Materials in ein Gas.
Procédé et dispositif pour vaporiser un liquide

(30) Priority: 14.09.1999 JP 26081999; 26.07.2000 JP 2000225445
(43) Date of publication of application: 21.03.2001
(73) Proprietor: STEC INC., Kyoto (JP)
(72) Inventor: Nishizato, Hiroshi, Minami-ku, Kyoto (JP); Miyamoto, Hideaki, Minami-ku, Kyoto (JP)
(74) Representative: Müller - Hoffmann & Partner

(56) References cited:
- EP-A- 0 602 595
- US-A- 5 431 763
- US-A- 5 865 421

## Description

### Detailed Description of the Invention

### Field of the Invention

This invention relates to a method and an apparatus for gasifying a liquid material such as tetraethoxysilane which is used for example for manufacturing a semiconductor.

### Background of the Invention

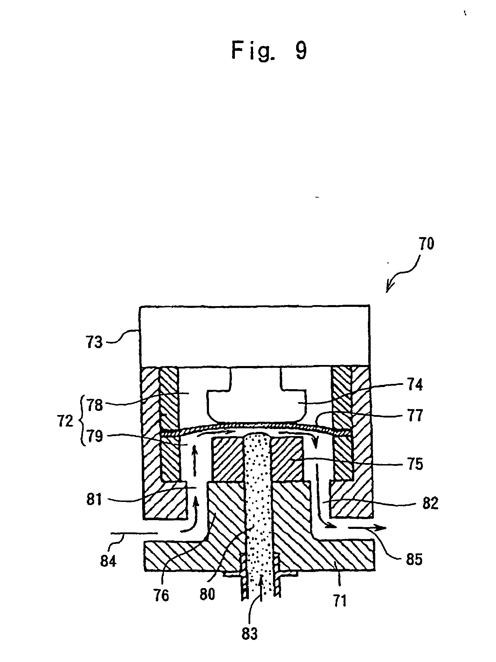

Among the conventional liquid material gasifying apparatus, there is one which is designed to gasify a liquid material in a control valve equipped with a flow control function, as described, for example, in U.S.P. No. 5419924. Fig. 9 is a view showing the principal part of the liquid material gasifying apparatus. In said figure, the part 70 is a control valve furnished with a flow control function, and in said valve body 71 there is formed a recess 72 which is open to upper part. And, the part 73 is a driving part provided to block the recess 72, and is furnished with a plunger 74 which rises and descends in the recess 72. The part 75 is a valve seat formed on the upper part of the projection 76 projecting upward from the center of the bottom face of the valve body 71. In addition, the part 77 is a flexible diaphragm which sections inside the recess 72 into the upper space 78 including the plunger 74 and the lower part space 79 including the valve seat 75, and is constituted to come into tight contact with the upper surface of the valve seat 75 by the descending of the plunger 74.

And, in Fig. 9, the part 80 is a liquid material introducing route which is formed to penetrate vertically from the center of the bottom face of the valve body 71 to the position with which the diaphragm 77 on the upper face of the valve seat 75 is in tight contact. The part 81 is a carrier gas induction route, and 82 is a mixed gas leading out route, which are all formed to communicate to the space formed around the valve seat 75 at the time when the diaphragm 77 is brought into tight contact with the upper face of the valve seat 75.

In the control valve 70 of the above constitution, a liquid material 83 from the liquid material tank (not illustrated) is led upward in the liquid material induction route 80 and introduced into the control valve 70 while controlling the flow, and a carrier gas 84 at high temperature (e.g., 70 °C) from the carrier gas source (not illustrated) is introduced into the control valve 70 through the carrier gas introducing route 81 and allowing the liquid material to be in contact with the high temperature carrier gas 84 to gasify the liquid material 83 into a material gas, so that this material gas is mixed with the carrier gas 84, and this mixed gas 85 is led outside the control valve 70 through the mixed gas lead out route 82.

### Problems to be solved by the Invention

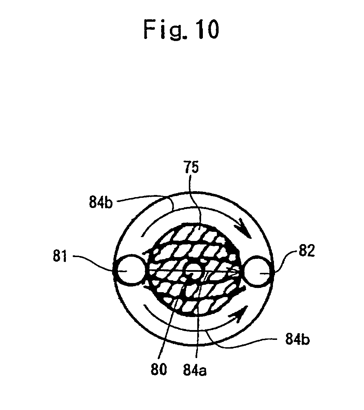

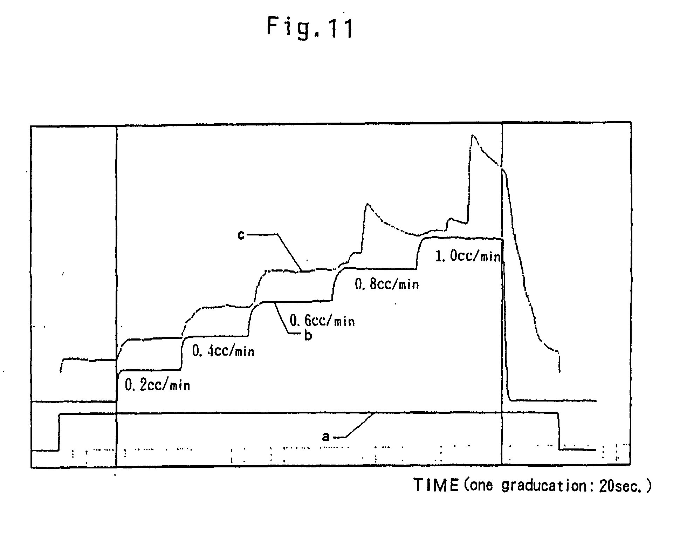

However, in the above liquid material gasifying apparatus, the efficiency for active use of the carrier gas 84 is poor, and there is a drawback that the liquid material 83 cannot always be gasified in stabilized state in good efficiency. This situation is explained while referring to Fig. 10 and Fig.11.

Firstly, Fig. 10 shows the flow of the liquid material 83 and the carrier gas 84 in the open state of the valve seat 75, in which the carrier gas 84 introduced into the lower space 79 through the carrier gas induction route 81 flows between the upper surface of the valve seat 75 and the diaphragm 77, as shown in an arrow mark 84a in the figure to come into contact with the liquid material 83 guided upward in the liquid material induction route 80. During this, majority part of the carrier gas 84 flows in a manner to take a roundabout way along the valve seat 75 and the projection 76 underneath, as shown in an arrow mark 84b in the figure. As a result of such flow, the introduced high temperature carrier gas 84 does not much contribute to acceleration of the gasification of the liquid material 83, and accordingly, the above partial pressure of local liquid comes to nearly saturated condition, so that condensation is apt to be formed.

And, in the above liquid material gasifying apparatus, there is a drawback that, when the amount of induction of the liquid material 83 into the control valve 70 increases, gasification of such material does not proceed in stable condition. That is to say, when the change in the gas flow led out from the control valve 70 was observed at the time of having increased stepwise the amount of induction of the liquid material 83 into the control valve 70 while retaining the amount of induction of the carrier gas 84 constant, the results as shown in fig. 11 were obtained.

In Fig. 11, the mark a shows an amount of induction of the carrier gas 84 which is in this example 2000 cc/min. and, the mark b shows the amount of induction of the liquid material (e.g., ethanol) 33 which is in this example changed stepwise from 0.2 cc/min. to 1.0 cc/min. Further, the mark c in the figure represents the change in flow volume of the gas led out from the control valve 70 as voltage change. From this Fig. 9, it can be seen that the gas flow volume changes in stabilized state while the induction amount of ethanol 83 is relatively small, ut when the induction amount increases, overshooting may occur or fluctuation may become vigorous.

This invention has been made with particular consideration of the matters given above. Its objects are to provide a mehtod for gasifying a liquid material and an apparatus thereof with which gasification of liquid material can be made efficiently and in stabilized state at all times.

This object is met by an apparatus for providing a controlled amount of gas from a liquid source according to claim 1 and corresponding method according to claim 2.

### Means for solving the problems

In order to attain the above object, the method for gasifying the liquid material according to this invention comprises mixing a liquid material and a carrier gas while making flow control in a gas-liquid mixing unit in a control valve provided with a liquid flow control function, and discharging the gas-liquid mixture at substantially the same time from the nozzle formed in the vicinity of the flow control unit to gasify the liquid material under reduced pressure.

According to the invention, for practicing the above liquid material gasifying method, an apparatus is used such that a liquid material supply line equipped with a raw material tank in which the liquid material is contained, and a flow meter for measuring the flow of the liquid material from the material tank and a carrier gas supply line euqipped with a carrier gas supply source and a flow control apparatus for controlling the flow of the carrier gas are connected with a control valve furnished with a liquid flow control function independently from each other, and a gas-liquid mixing unit and a nozzle unit are formed in close relations with each other in the control valve, so that the liquid materials introduced into the control valve by the above liquid material supply line are mixed with the carrier gas introduced into the control valve by the carrier gas supply line in said gas-liquid mixing unit while controlling the flow volume, the resulting gas-liquid mixture is discharged from the above nozzle to gasify the liquid material under reduced pressure, and the gas formed by gasification, along with the carrier gas, is taken out from the gas leading out route on the downstream side of the nozzle.

Flow control of the liquid material in the above control valve may be made based on the output of the flow meter for liqud or the output of the flow meter for gas provided on the gas leading out line communicating with the gas leading out route.

According to the invention, the liquid material and the carrier gas are mixed while controlling the flow in the gas and liquid mixing unit in the control valve equipped with a liquid flow control function, and the gas-liquid mixture can be subjected to reduced pressure instantly at the nozzle, so that the liquid material can be gasified in good efficiency and in stabilized condition.

Details of the invention and preferred embodiments thereof will be described in the following with reference to the accompanying drawings.

### Brief description of the Drawings

Fig. 1 is a view to show schematically the whole constitution of the liquid material gasifying apparatus according to this invention.
Fig. 2 is a vertical section showing an example of the control valve in the above liquid material gasifying apparatus.
Fig. 3 is a perspective view of a vertical section showing a constitution of the essential part in said control valve.
Fig. 4 is a view for explaining the motion of the above control valve, wherein (A) is a view showing the closed condition of the valve, and (B) is a view showing the open condition of the valve.
Fig. 5 is a view for explaining the motion of the above gas-liquid mixing unit.
Fig. 6 is a view for explaining the gasification condition with the above liquid material gasifying apparatus.
Fig. 7 is a view for illustrating the gasification condition of trimethyl phosphate with the liquid material gasifying apparatus.
Figs. 8 (A), (B) and (C) are the explanatory views showing by comparing the deposition conditions of trimethyl phosphate decomposition matters in the vicinity of the valve seat.
Fig. 9 is a vertical section showing an essential part of the conventional liquid material gasifying apparatus.
Fig. 10 is an explanatory view of the motion of the above conventional liquid material gasifying apparatus.
Fig. 11 is a view for explaining the gasification condition with the above conventional liquid material gasifying apparatus.

### Explanations of letters or numerals

1 ... Control valve, 2 ... Liquid material supply line, 3 ... Carrier gas supply line, 4 ... Gas leading out line, 5 ... Raw material tank, 8 ... Flow meter for liquid, 12 ... Carrier gas supply source, 16 ... Flow control apparatus for gas, 18 ... Flow meter for gas, 25 ... Gas leading out route, 39 ... Gas-liquid mixing unit, 42 ... Nozzle, LM ... Liquid material, CG ... Carrier gas, M ... Gas-liquid mixture, KG ... Mixed gas.

### Preferred Embodiment of the Invention

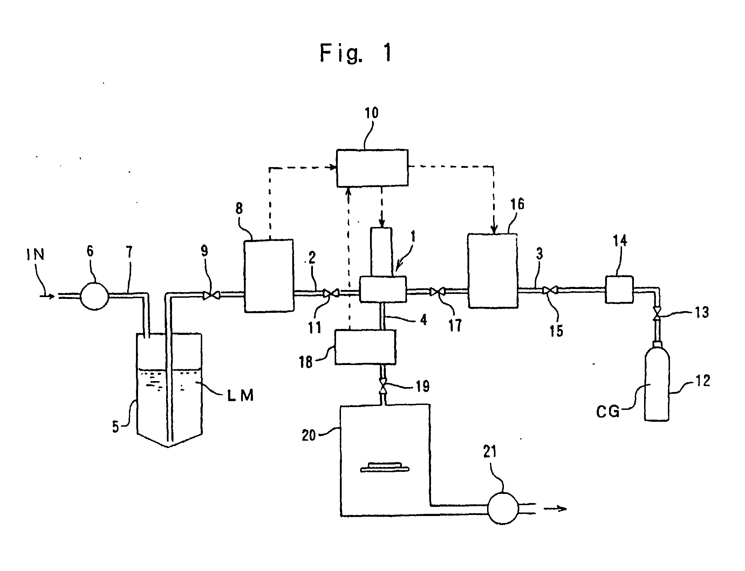

An embodiment of this invention is explained while referring to the drawings. Fig. 1 shows schematically the whole constitution of the liquid material gasifying apparatus. In this figure, the part 1 shows a control valve equipped with a liquid flow control function (the constitution thereof is explained in detail later), and for example on the left side part thereof a liquid material supply line 2 is connected, on the right side part a carrier gas supply line 3 is connected, and on the lower side part a gas leading out line 4 is connected.

The liquid material supply line 2 is constituted as follows: Namely, the part 5 is a raw material tank provided in the liquid material supply line 2, in which a liquid material LM is contained in gas-tight condition, and on the upstream side thereof an inert gas supply pipe 7 having a regulator 6 is connected. And, it is so constituted that, by the supply of the inert gases such as N₂, He, Ar and the like to the upper space in the raw material tank 5 from the IN in the figure, the liquid material LM is extruded into the liquid material supply line 2. The part 8 is a flow meter for liquid provided on the downstream side of the raw material tank 5 through the open/close valve 9 to measure the flow volume of the liquid material LM flowing from the raw material tank 5 side. As a flow meter for liquid 8, there can be used, for example, a known liquid mass flow meter. And, the results of detection with the liquid flow meter 8 are sent out to the apparatus control unit 10 which controls the whole apparatus or carries out operation based on the detected signal and the like. The part 11 is an open/close valve interposed between the flow meter for liquid 8 and the control valve 1.

The above carrier gas supply line 3 is constituted in the following manner. Namely, the part 12 is a carrier gas supply source provided on the upstream side of the carrier gas supply line 3 to supply any of the inert gases such as N₂, He, Ar, and the like as a carrier gas CG. On the downstream side of it there are provided a regulator 14 through an open/close valve 13, and further a flow control apparatus for gas 16 through an open/close valve 15. This flow control apparatus for gas 16 is to make control so that the carrier gas CG to be supplied to the control valve 1 becomes a fixed amount, in which the aperture is regulated on the basis of the control signal from the apparatus control unit 10. As the flow control apparatus for gas 16, for example, a known gas mass flow controller can be used. The part 17 is an open/close valve to be interposed between the flow control apparatus for gas 16 and the control valve 1.

The gas leading out line 4 is constituted in the following manner. The part 18 is a flow meter for gas to be interposed on the gas leading out line 4, and is designed to measure the flow of the gas (as described later, a mixed gas of a gas formed by gasification of the liquid material LM with the carrier gas CG) led from the control valve 1, and the results of the measurement are sent to the apparatus control unit 10. As this flow meter for gas 18, there can be used, for example, a known gas mass flow meter. And, on the downstream side of this flow meter for gas 18 there is provided a reaction furnace 20 as a use point through the open/close valve 19. This reaction furnace 20 is a semiconductor manufacturing apparatus such as for example a CVD apparatus. The part 21 is a suction pump to be connected to the reaction furnace 20.

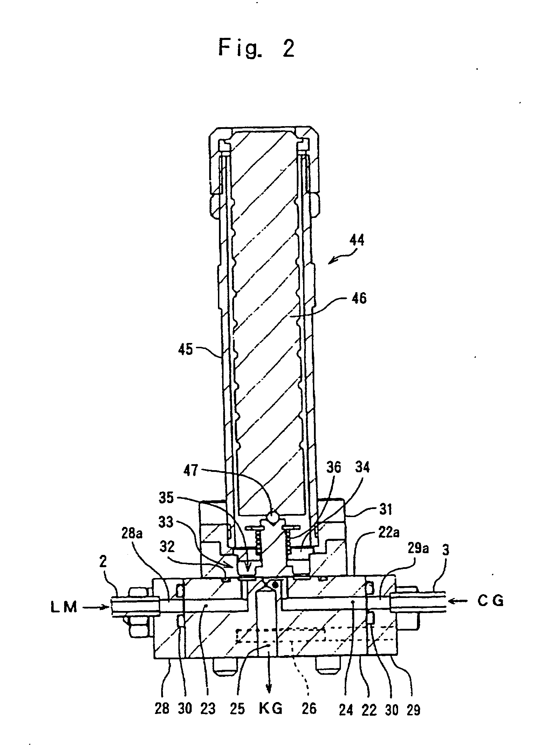

Next, the control valve 1 is explained while referring to Figs. 2 to 5. Firstly, in Fig. 2, the part 22 is for example a rectangular parallelepiped shaped body block, comprising, for example, a material rich in heat resistance and corrosion resistance, like a stainless steel. Inside this body block 22 there are formed three flow routes 23, 24, and 25.

The above flow route 23 introduces the liquid material LM into the gas-liquid mixing unit 39 to be described later. This liquid material induction route 23 shows a reverse L-letter shape such that its one end is open to the left side face of the body block 22, and the other end is open to the upper face of the body block 22. And, the flow route 24 introduces the carrier gas CG into the gas liquid mixing unit 39. This carrier gas induction route 24 shows an L-letter shape such that its one end is open to the right side face of the body block 22, and the other end is open to the upper face of the body block 22. The flow route 25 is to function as a gas leading out route. This gas leading out route 25 opens at its one end to the lower face of the body block 22, and at the other end it is formed in nearly a straight line up to the appropriate position of the body block 22, with its upper end side being linked with the gas-liquid mixing unit 39 through the nozzle 42 to be described later.

Further, the part 26 is a heater for heating the whole body block 22, comprising for example a cartridge heater, which is self-contained in freely detachable manner in the vicinity of the gas leading out route 25. The part 27 is a thermocouple as a temperature sensor for detecting the temperature of the body block 22.

And, the parts 28, 29 are the connection blocks to be provided in freely detachable manner through a seal member 30 on the right and left side faces of the body block 22. To each of the blocks 28, 29, there are formed the flow routes 28a, 29a which are communicate with the liquid material induction route 23 and carrier gas induction route 24, respectively, so that the respective parts of the liquid material induction route 23 and the carrier gas induction route 24 are to be connected with the external liquid material supply line 2 and the carrier gas supply line 3, through the blocks 28, 29. In Fig. 2, no reference is made to the connection structure between the gas leading out route 25 and the external gas leading out line 4, but needless to say, an appropriate connecting member is used to make the predetermined connection.

Next, the constitution in the upper face of the above body block 22 is explained while referring to Figs. 2 to 4. In Fig. 2, the part 31 is a valve block, which is placed on the upper face 22a of the body block 22 through the O-ring 32, and comprises the materials having good heat conductivity and corrosion resistance such as stainless steel. Between this valve block 31 and the upper face 22a, there is formed a valve body 33 having liquid flow control function. That is to say, in the internal space 34 of the valve block 31, a diaphragm 35 is provided in a manner to be normally forced upward by a spring 36.

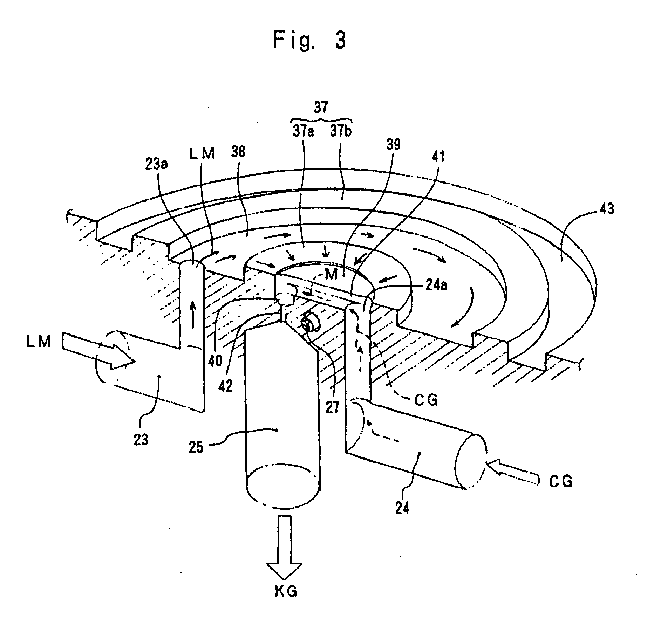

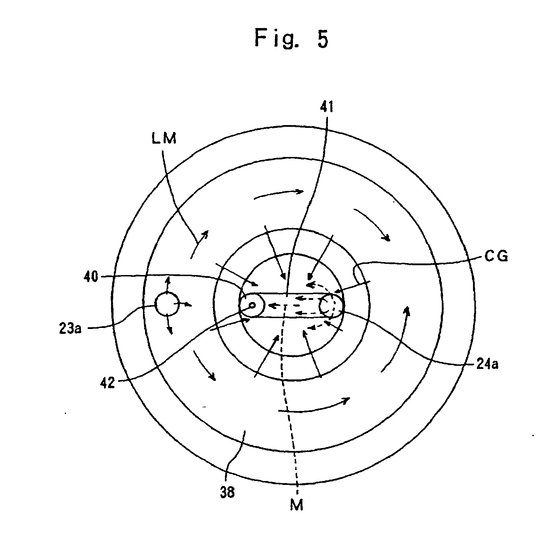

Here, to explain the constitution in the upper face 22a of the body block 22 with reference to Fig. 3 and Fig. 5, the part 37 is a valve seat to be formed in approximately the central part of the above top face 22a, and comprises the two annular partition walls 37a, 37b, and constitutes the valve body 33 along with the diaphragm 35. And, the recess 38 which is annular when viewed in plane surrounded by the two valve seats 37a, 37b is formed in a manner to include the opening 23a of the liquid material induction route 23 on the downstream side, and functions as a liquid flow route.

In the recess 39 which is circular when viewed in plane surrounded by the inside valve seat 37a, as shown in Fig. 5, there are provided an opening 24a on the downstream side of the carrier gas induction route 24 and a hole 40 led to the gas leading out route 25, and a shallow slender groove 41 including these openings 24a and hole 40 is formed. It is so constituted that the carrier gas CG flowing in from the opening 24a and the liquid material LM flowing in from the gap between the inside valve seat 37a and the diaphragm 35 are mixed, and the system functions as a gas liquid mixing unit.

And, the part 42 is a nozzle to be formed between the above hole 40 and the gas leading out route 25. This nozzle 42 has considerably small diameter and length such that the diameter is no more than 1.0 mm, and the length is no more than 1.0 mm. Further, this nozzle 42 is provided in as close as possible to the gas liquid mixing unit 39. And, in this nozzle 42, a gas-liquid mixture M formed in the gas-liquid mixing unit 39 is discharged into the gas leading out route 25, by which the liquid material LM included in the gas-liquid mixture M is subjected to reduced pressure to be gasified. The resulting gas is mixed with the carrier gas CG to become a mixed gas KG.

In Fig. 3, the part 43 is an O-ring groove to be formed on the outside of the outside valve seat 37b, in which the above O-ring 32 is charged.

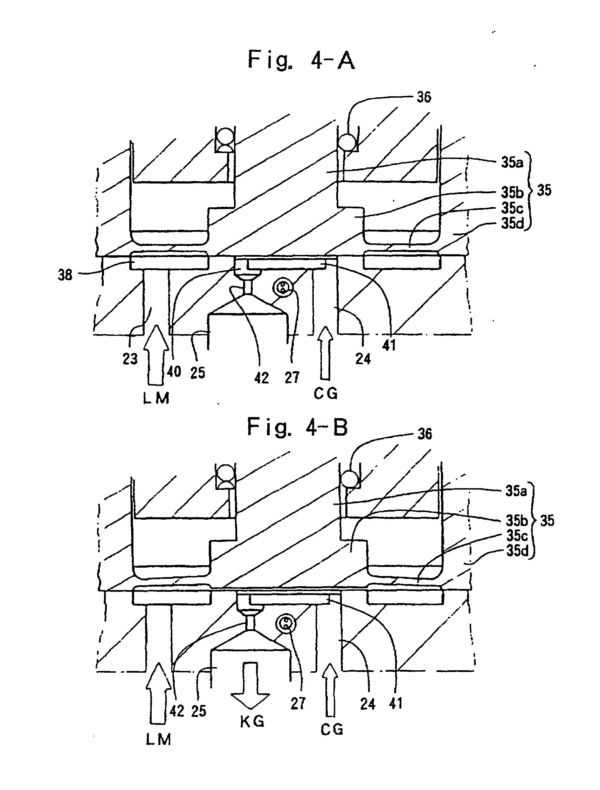

And, the diaphragm 35 comprises a material having good heat resistance and corrosion resistance and adequate elasticity, and as shown in Fig. 4 (A), (B), it includes a valve unit 35b which comes into contact with or alienates from the upper face of the valve seat 37a underneath the shaft 35a, and has a thin wall part 35c around it, and further, comprises a thick wall part 35d around the thin wall part 35c. It is so constituted that, in ordinary time, by being forced upward by a spring 36, the valve part 35b is separated from the valve seat 37a, but when a pressing force downward acts to the shaft 35a, the valve 35b is displaced in a direction to come into contact with the valve seat 37a.

The part 44 is an actuator for pressing the diaphragm 35 downward to distort it. In this embodiment, this is constituted into a piezo-actuator in which a piezo-stack 46 is provided by laminating a plurality of piezoelectric elements in a housing 45 erected on the upper part of the valve block 31, and the pressing part 47 underneath the piezo-stack 46 is brought into contact with the axial part 35a of the diaphragm 35.

An operation of the liquid material gasifying apparatus constituted in the above manner is explained. When the inert gas is supplied to the raw material tank 5, the liquid material LM in the raw material tank 5 is pressurized, and the liquid material LM flows in the liquid material supply line 2 in the direction of the control valve 1. The flow of this liquid material LM is measured by the liquid flow meter 8, and the results of the measurement are inputted to the apparatus control unit 10. And, the liquid material LM is introduced into the control valve 1. And, a control signal is sent to the control valve 1 from the apparatus control unit 10 so as to make the flow proportionate to the liquid flow setting signal. In consequence, a piezo-actuator 44 is operated to adjust the aperture of the valve body 33. As a result, the liquid material LM which is introduced into the control valve 1 reaches the liquid flow route 38 through the liquid material induction route23, and further, as shown in Figs. 3 and 5, goes into the gas-liquid mixing unit 39 which is brought to an appropriate temperature through the gap between the valve seat 37a and the valve part 35b of the diaphragm 35 from the liquid flow route 38.

On the other hand, the carrier gas CG from the carrier gas supply source 12 is subjected to flow control in the flow control apparatus for gas 16 and sent in the direction of the control valve 1 to a gas-liquid mixing unit 39 in the control valve 1. The carrier gas CG which is introduced into the control valve 1 is sent into the gas-liquid mixing unit 39 through the carrier gas induction route 24, as shown in Fig. 3.

The liquid material LM and the carrier gas CG which entered into the above gas-liquid mixing unit 39 are mixed with each other. Especially, a slender groove 41 is formed on the gas-liquid mixing unit 39, and as the liquid material LM is mixed with the carrier gas CG while flowing into the groove 41, the two members LM and CG are sufficiently mixed together to become a gas-liquid mixture M.

And, the above gas-liquid mixture M is led through the hole 40 of the gas-liquid mixing unit 39 and discharged to the gas leading out route 25 from the nozzle 42. At this time, the liquid material LM in the gas-liquid mixture M is subjected to reduced pressure instantly to become a gas. This gas is mixed with the carrier gas CG in the gas-liquid mixture M to become a mixed gas KG and flown to downstream side through the gas leading out route 25. At this time, as the gas leading out route 25 is heated by the heater 26, no dew condensation should occur.

The above carrier gas CG shows a high pressure condition at the front side of the nozzle 42 (upstream side), and is heated to elevate the temperature in good efficiency by the above heater 26. In addition, because it is not only the case for the heating efficiency of the carrier gas CG per se to rise by the above heater 26 but also the above liquid material LM is compulsorily mixed with the carrier gas CG in the nozzle 42, heat transfer from the carrier gas CG to the liquid material LM is to progress in good efficiency. Due to these factors, heat transfer efficiency from the heater 26 to the liquid material LM is elevated, and the gasification efficiency of the liquid material LM is increased, and the flow of the gasified liquid material LM is enlarged, with the result that the lowering of the temperature necessary for gasifying the liquid material LM becomes possible, so that curtailment of the energy cost can be schemed.

In addition, the gas concentration of the liquid material LM which is discharged from the nozzle 42 and gasified in the process where the gas-liquid mixture M is led from the gas-liquid mixed part 39 to the downsteam side of the gas leading out route 25 is to be lowered by the presence of the carrier gas CG, and, accompanied with this, the temperature necessary for preventing the gasified liquid material LM from being liquefied and forming dewdrop in the gas leading out route 25 is lowered, with the result that it becomes possible to curtail the energy cost for heating the gas leading out route 25. Besides, as the liquid material LM loses its heat by adiabatic expansion at the time when it is discharged from the nozzle 42 and gasified, normally gasification efficiency is lowered, but in this embodiment, it is possible to supplement the heat lost by the liquid material LM by the carrier gas CG to be mixed with the liquid material LM, and thereby making it possible to achieve an improvement in the gasification efficiency of the liquid material LM.

And, the above mixed gas KG is supplied to the reaction furnace 20 which is a use point through the gas leading out line 4 on the downstream side of the gas leading out route 25. At this time, the flow of the mixed gas KG is measured by the flow meter for gas 18 interposed in the gas leading out line 4, and the results thereof are sent to the apparatus control unit 10.

As described above, in the liquid material gasifying apparatus of this invention, in the gas-liquid mixing unit 39 formed in the control valve 1 furnished with a liquid flow control function, a liquid material LM is mixed with the carrier gas CG under flow control, at which time the gas-liquid mixture M is discharged from the nozzle 42 positioned in the vicinity of the gas liquid mixing unit 39 to subject the liquid material LM to reduced pressure to gasify, so that it is possible to discharge the gas-liquid mixture M in the favorably mixed condition from the nozzle 42, and to gasify the liquid material LM in the gas-liquid mixture M in good efficiency and stabilized condition, to supply a gas containing vapor of certain concentration in a stabilized state.

In the liquid material gasifying apparatus of the present invention, transportation of the liquid material LM to the reaction furnace 20 is performed by placing on (mixing with) the carrier gas CG which can be led at a high speed, so that it is possible to send the liquid material LM to the reaction furnace 20 at a high speed, and thus it is possible to meet the case where high speed response is required.

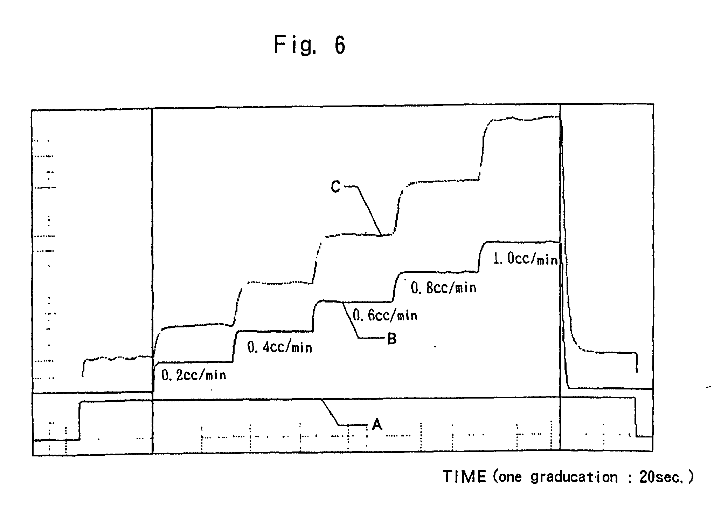

Fig. 6 shows the measurement data obtained at the time of gasifying the liquid material LM by the above liquid material gasifying apparatus, which represents the results of observation of the change in the mixed gas KG which is led out from the control valve 1 at the time when the induction amount of the liquid material LM into the control valve 1 is stepwise increased while retaining the amount of induction of the carrier gas CG constant.

That is to say, in case of supplying a carrier gas CG at the rate of 2000 cc/min., and ethanol as a liquid material LM at the rate of 1 cc/min. to a reaction furnace 20, by making the diameter of the nozzle 42 0.3 mm and the length 0.6 mm when the temperature of the heater 26 of the control valve 1 is 80°C, the pressure of the gas liquid mixing unit 39 becomes about 30 kpa. At this time, the gas liquid mixture M in the gas-liquid mixing unit 39 is discharged from the nozzle 42 to observe the condition when the liquid material LM in the gas-liquid mixture M is gasified under reduced pressure and supplied to the reaction furnace 20.

In this figure 6, the mark A shows an induction amount of the carrier gas CG, which is, in this example, 2000 cc/min. And, the mark B shows change of the induction amount of the ethanol as a liquid material LM, which shows in this example stepwise change from 0.2 cc/min. to 1.0 cc/min. Also, the mark C in the figure represents the change in flow of the mixed gas KG led out from the control valve 1 as a change in voltage.

It can be observed from Fig. 6 above that the output C of the flow meter for gas 18 is stabilized between 0.2 cc/min. and 1.0 cc/min., so that the gasification of the liquid material LM is stabilized. In other words, according to the liquid material gasifying apparatus of the above constitution, it is possible to gasify in stabilized state the larger amount of the liquid material LM than with the conventional gasifying apparatus and generate the desired gas.

And, as the above liquid material gasifying apparatus is designed to carry out flow control of the liquid material LM in the control valve 1 based on the output of the flow meter for liquid 8, the liquid material LM can be supplied in an optimum amount to the gas liquid mixing unit 39.

This invention is not limited to the above embodiment but may be practiced in various modifications. That is to say, the liquid material induction route 23 and the carrier gas induction route 24 is not necessarily formed into a hook shape but may be straight. And, the heater 26 may be a plate heater. The heating temperature by the heater 26 may be optionally set according to the kind of the liquid material LM and the like. This heater 26 may be made to heat the neighborhood of the gas-liquid mixing unit 39 of the body block 22 or the gas leading out route 25, and especially, it may be made to such a degree that the pressure is reduced by discharging a liquid material LM from the nozzle 42 to make it possible to form a gas suitably.

And, flow control of the liquid material LM in the control valve 1 may be made based on the output of the flow meter for gas 18 provided on the gas leading out line 4, and when such arrangement is made, flow of the liquid material LM can be controlled in a higher precision.

Furthermore, as an actuator 44, an electromagnetic type one or a thermal system one may be used.

Further, the liquid material LM is not limited to ethanol but it may be, for example, pentaethoxytantalum (PETa), trimethyl phosphate (TMPO), and the like.

Furthermore, the liquid material LM is not limited to one which is in liquid state at room temperature and under normal pressure but one which, though being gas phase at room temperature and under normal pressure, can be liquid at room temperature by optionally being pressurized.

In addition, the reaction vessel 20 may be a vacuum vessel, in which case a gas leading out line 4 may be put under reduced pressure.

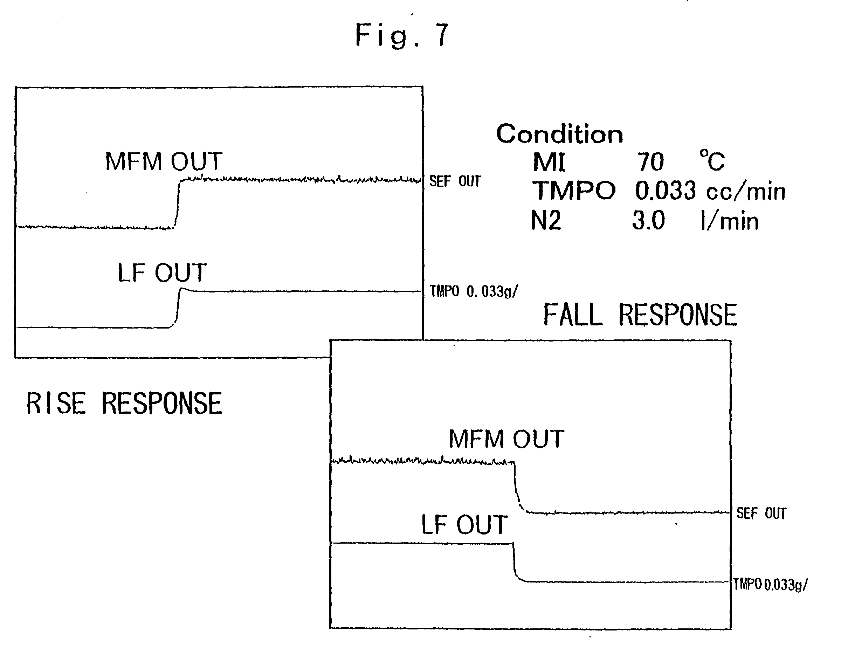

Fig. 7 shows the measurement data obtained with the above liquid material gasifying apparatus at the time when trimethyl phosphate (TMPO) as a liquid material LM is gasified, which represents the results of observation of the change in the mixed gas KG led out from the control valve 1 at the time when the amount of introduction of the liquid material LM into the control valve 1 is instantaneously increased and decreased while keeping the amount of introduction into the control valve 1 of N₂ as a carrier gas CG.

That is to say, in case of supplying the above carrier gas CG at the rate of 3.0 L/min. and the liquid material LM at the rate of 0.033 cc/min. to the reaction furnace 20, observation is made on the condition where, with the temperature of the heater 26 of the control valve 1 set at 70°C, the liquid material LM in the gas-liquid mixture M is gasified under reduced pressure and supplied to the reaction furnace 20. In each graph shown in Fig. 7, the abscissa represents the time, and the ordinate represents the output size of the flow meter 8 for liquid and the flow meter 18 for gas.

In order to flow the trimethyl phosphate (TMPO) with conventional liquid material gasifying apparatus at 0.033 cc/min. to generate gas by gasification, a temperature of 130°C required. However, at such a high temperature, there was a problem that TMPO showed self-decomposition and the decomposed matter was accumulated on the control valve to cause blocking. However, according to the liquid material gasification apparatus of the present invention, it is possible to flow TMPO at 70°C at which self-decomposition of TMPO scarcely takes place at 0.3 cc/min. to cause gasification and generation, and as apparent from the fact that the output of the flow meter 18 for gas follows the change of output of the flow meter 8 for liquid at the time when the flow of TMPO is instantaneously increased from zero to 0.033 cc/min. and the change of output of the flow meter 8 for liquid at the time when the flow of TMPO is instantaneously lowered from 0.033 cc/min. to zero, gasification of TMPO is performed with stability.

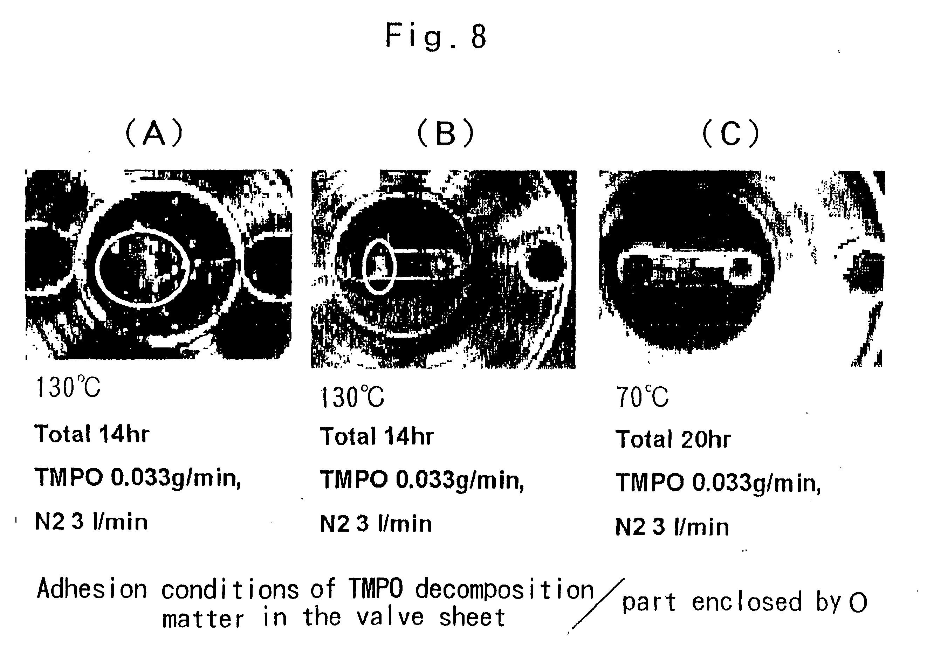

Fig. 8 is an illustrative view showing in comparison the adhesion conditions of TMPO in the vicinity of the valve sheet 37, wherein the same Fig. (A) shows the results of the case of supplying the carrier gas CG at 3.0 L/min. and the liquid material LM at 0.033 cc/min. for 14 hours with the temperature in the vicinity of the valve seat set at 130°C, using the conventional liquid material gasifying apparatus, the same Fig.(B) shows the results of the case of supplying the carrier gas CG at 3.0 L/min. and the liquid material LM at 0.033 cc/min. for 14 hours with the temperature in the vicinity of the valve seat 37 set at 130 °C, using the liquid material gasifying apparatus of the present invention, and the same Fig. (C) shows the results of the case of supplying the carrier gas CG at 3.0 L/min. and supplying the liquid material LM at 0.033 cc/min. for 20 hours with the temperature in the vicinity of the valve seat 37 set at 70°C, using the liquid material gasifying apparatus of the present invention, respectively.

It can be observed from Fig. 8 (A) and (B) that, in case the temperature is set at 130°C, even by using the liquid material gasifying apparatus of the present invention, deposition of TMPO decomposition matter in the vicinity of the valve seat 37 occurs, but the deposition area becomes small in comparison with the case of using the conventional liquid material gasifying apparatus. Furthermore, it can be seen from Fig. 8 (C) that, in case of using the and setting the temperature at 70 °C, there is scarce deposition of TMPO decomposition matter in the vicinity of the valve seat 37.

In other words, according to the liquid material gasifying apparatus of the present invention, heating temperature required for gasifying liquid can be lowered, and even in case of gasifying the liquid material which shows decomposition at a high temperature, it becomes possible to suppress such decomposition.

### Effect of the Invention

As described above, according to this invention, a liquid material and a carrier gas are mixed while making flow control in a gas-liquid mixing unit in the control valve provided with a liquid flow control function, and this gas-liquid mixture is subjected to reduced pressure at the nozzle. Accordingly, the liquid material can be gasified in good efficiency and under stabilized condition.

## Claims

1. An apparatus for providing a controlled amount of gas from a liquid source
**characterized by**
a) a liquid material supply line (2) being equipped with a raw material tank (5) in which the liquid material (LM) is comprised and a flow meter (8) for measuring the flow of the liquid material from the raw material tank (5);
b) a carrier gas supply line (3) being equipped with a carrier gas supply source (12) and a flow control apparatus (16) for controlling the flow of the carrier gas;
c) said liquid material supply line (2) and said carrier gas supply line (3) being connected with a control valve (1) furnished with a liquid flow control function independently from each other;
d) a control valve (1) including:
d1) a valve body (33) having a valve seat (37) being comprised of two annular partition walls (37a, 37b) forming a recess (38) inbetween, said recess having an opening (23a) being connected to said liquid material supply line (2);
d2) a gas-liquid mixing unit (39) formed inside the inner partition wall (37a) of said valve seat (37) being provided with an opening (24a) being connected with said carrier gas supply line (3);
d3) a diaphragm (35) seated on said valve seat and adapted to be lifted from said valve seat to thereby create a gap between said valve seat and said diaphragm to enable said liquid material to be introduced radially in said gas-liquid mixing unit; and
d4) a nozzle unit (42) positioned in the vicinity of said gas-liquid mixing unit (39) for mixing said liquid with said carrier gas and gasifying said liquid material under reduced downstream pressure;
e) a control unit (10) connected to said flow control apparatus (16) for controlling the flow of the carrier gas and said control valve for controlling the production of gas, said control unit being able to regulate the quantity of liquid and mixing the carrier gas with the liquid upstream of the nozzle unit (42), whereby the liquid is gasified under reduced downstream pressure.

2. A method for providing a controlled amount of gas from a liquid source
**characterized by**
- introducing a liquid material while performing flow control of said liquid material and introducing a carrier gas while performing flow control of said carrier gas into a gas-liquid mixing unit in a control valve provided with a liquid flow control function, wherein said liquid material is introduced radially in said gas-liquid mixing unit;
- discharging the gas-liquid mixture from a nozzle formed in the vicinity of said flow control unit to gasify the liquid material under reduced pressure to form a gas while performing flow control of said gas.

3. The method as claimed in claim 2, **characterized in that** flow control of the liquid material in the control valve is made based on flow control of said liquid material or based on flow control of said gas.

## Patentansprüche

1. Vorrichtung zur Bereitstellung einer kontrollierten Menge an Gas aus einer flüssigen Quelle, **gekennzeichnet durch**
a) eine Flüssigmaterial-Zuführleitung (2), die mit einem Rohmaterialtank (5), in dem sich das flüssige Material (LM) befindet und einem Flussmesser (8) zur Messung des Flusses des flüssigen Materials aus dem Rohmaterialtank (5) ausgestattet ist;
b) eine Trägergas-Zuführleitung (3), die mit einer Trägergas-Zuführquelle (12) und einer Flusssteuerungsvorrichtung (16) zur Steuerung des Flusses des Trägergases ausgestattet ist;
c) wobei die Flüssigmaterial-Zuführleitung (2) und die Trägergas-Zuführleitung (3) mit einem Steuerventil (1), ausgestattet mit voneinander unabhängigen Flüssigkeitsflusssteuerfunktionen, verbunden sind;
d) wobei das Steuerventil (1) umfasst:
d1) einen Ventilkörper (33) mit einem Ventilsitz (37), der aus zwei ringförmigen Teilwänden (37a, 37b) aufgebaut ist, die dazwischen eine Ausnehmung (38) bilden, wobei die Ausnehmung eine Öffnung (23a) aufweist, die mit der Flüssigmaterial-Zuführleitung (2) verbunden ist;
d2) eine Gas-Flüssig-Mischeinheit (39), gebildet innerhalb der inneren Teilwand (37a) des Ventilsitzes (37), versehen mit einer Öffnung (24a), die mit der Trägergas-Zuführleitung (3) verbunden ist;
d3) ein Diaphragma (35), positioniert auf dem Ventilsitz und angepasst, um vom Ventilsitz abgehoben zu werden, um hierdurch eine Lücke zwischen dem Ventilsitz und dem Diaphragma zu erzeugen, um es dem Flüssigmaterial zu ermöglichen, radial in die Gas-Flüssig-Mischeinheit eingeführt zu werden; und
d4) eine Düseneinheit (42), positioniert in der Nähe der Gas-Flüssig-Mischeinheit (39) zum Mischen der Flüssigkeit mit dem Trägergas und in Gasform überführen des Flüssigmaterials unter reduziertem Stromabwärtsdruck;
e) eine Steuereinheit (10), verbunden mit der Flusssteuerungsvorrichtung (16) zur Steuerung des Flusses des Trägergases und dem Steuerventil zur Steuerung der Gasherstellung, wobei die Steuereinheit in der Lage ist, die Menge an Flüssigkeit zu regulieren und das Trägergas mit der Flüssigkeit stromaufwärts von der Düseneinheit (42) zu mischen, wodurch die Flüssigkeit unter reduziertem Stromabwärtsdruck in Gasform überführt wird.

2. Verfahren zur Bereitstellung einer kontrollierten Menge an Gas aus einer flüssigen Quelle, **gekennzeichnet durch**
- Einführen eines Flüssigmaterials, während Flusssteuerung des Flüssigmaterials durchgeführt wird, und Einführen eines Trägergases, während Flusssteuerung des Trägergases durchgeführt wird, in eine Gas-Flüssig-Mischeinheit in einem Steuerventil, ausgestattet mit einer Flüssigkeitsflusssteuerungsfunktion, worin das Flüssigmaterial radial in die Gas-Flüssig-Mischeinheit eingeführt wird;
- Auslassen der Gas-Flüssigkeits-Mischung **durch** eine Düse, gebildet in der Nähe der Flusssteuerungseinheit, um das Flüssigmaterial unter reduziertem Druck in Gas zu überführen, um ein Gas zu bilden, während Flusssteuerung des Gases durchgeführt wird.

3. Verfahren nach Anspruch 2, **dadurch gekennzeichnet, dass** die Flusssteuerung des Flüssigmaterials im Steuerventil basierend auf der Flusssteuerung des Flüssigmaterials oder basierend auf der Flusssteuerung des Gases durchgeführt wird.

## Revendications

1. Appareil pour fournir une quantité contrôlée de gaz à partir d'une source de liquide, **caractérisé par**
a) une ligne d'alimentation en substance liquide (2) équipée d'un réservoir de substance brute (5) dans lequel la substance liquide (LM) est contenue et d'un débitmètre (8) destiné à mesurer le débit de la substance liquide sortant du réservoir de substance brute (5);
b) une ligne d'alimentation en gaz porteur (3) équipée d'une source d'alimentation en gaz porteur (12) et d'un appareil régulateur de débit (16) destiné à réguler le débit du gaz porteur;
c) ladite ligne d'alimentation en substance liquide (2) et ladite ligne d'alimentation en gaz porteur (3) étant reliées à une soupape de régulation (1) dotée d'une fonction de régulation de débit de liquide, de manière indépendante l'une de l'autre;
d) la soupape de régulation (1) comprenant:
d1) un corps de soupape (33) comportant un siège de soupape (37) constitué de deux parois de séparation annulaires (37a, 37b) formant une cavité (38) entre elles, ladite cavité possédant un orifice (23a) relié à ladite ligne d'alimentation en substance liquide (2);
d2) une unité de mélange gaz/liquide (39) formée à l'intérieur de la paroi de séparation intérieure (37a) dudit siège de soupape (37) qui comporte un orifice (24a) relié à ladite ligne d'alimentation en gaz porteur (3);
d3) un diaphragme (35) monté sur ledit siège de soupape et adapté pour être soulevé par rapport audit siège de soupape pour ainsi créer un espace entre lui et ledit siège de soupape afin de permettre l'introduction radiale de ladite substance liquide dans ladite unité de mélange gaz/liquide; et
d4) une unité formant buse (42) positionnée au voisinage de ladite unité de mélange gaz/liquide (39) pour mélanger ledit liquide avec ledit gaz porteur et gazéifier ladite substance liquide sous une pression aval réduite;
e) une unité de commande (10) reliée audit appareil régulateur de débit (16) pour commander le débit du gaz porteur et à ladite soupape de régulation pour commander la production de gaz, ladite unité de commande étant apte à réguler la quantité de liquide et à mélanger le gaz porteur avec le liquide en amont de l'unité formant buse (42), pour qu'ainsi le liquide soit gazéifié sous une pression aval réduite.

2. Procédé pour fournir une quantité contrôlé de gaz à partir d'une source de liquide, **caractérisé par** les étapes qui consistent à
- introduire une substance liquide tout en effectuant une régulation du débit de ladite substance liquide et introduire un gaz porteur tout en effectuant une régulation du débit dudit gaz porteur dans une unité de mélange gaz/liquide formée dans une soupape de régulation dotée d'une fonction de régulation de débit de liquide, ladite substance liquide étant introduite radialement dans ladite unité de mélange gaz/liquide;
- délivrer le mélange gaz/liquide à partir d'une buse formée au voisinage de ladite unité de régulation de débit afin de gazéifier la substance liquide sous une pression réduite pour former un gaz tout en effectuant une régulation du débit dudit gaz.

3. Procédé tel que défini dans la revendication 2, **caractérisé en ce que** la régulation du débit de la substance liquide dans la soupape de régulation est réalisée à partir de la régulation du débit de ladite substance liquide ou de la régulation du débit dudit gaz.
